# EUROPEAN PATENT APPLICATION

(11) **EP 3 032 579 A1**
(43) Date of publication of application: **15.06.2016**
(21) Application number: 15197317.9
(22) Date of filing: 01.12.2015
(51) Int. Cl.: H01L 21/8252, H01L 27/06, H01L 27/085, H01L 29/10

(54) **AN INTEGRATED CIRCUIT COMPRISING GROUP III-N TRANSISTORS MONOLITHICALLY INTEGRATED ON A SILICON SUBSTRATE AND A METHOD FOR MANUFACTURING THEREOF**

(30) Priority: 09.12.2014 EP 14196952
(71) Applicant: IMEC VZW, 3001 Leuven (BE)
(72) Inventor: Decoutere, Stefaan, 3001 Leuven (BE); Posthuma, Niels, 3001 Leuven (BE); You, Shuzhen, 3001 Leuven (BE)
(74) Representative: Patent Department IMEC

(57) **Abstract**

An integrated circuit (1) comprising a first III-N transistor (5) having a source region (8) and a second III-N transistor (6) having a source region (9), both transistors being monolithically integrated on a common silicon substrate (2) of a first doping type and separated from each-other by an isolation region (7),the substrate (2) comprising underneath the first transistor (5) a well (3) of a first doping type electrically connected to the source region (8) of the first transistor (5) and comprising underneath the second transistor (6) a well (4) of a second doping type electrically connected to the source region (9) of the second transistor (6), thereby forming a junction diode (10) in the substrate (2) between the sources (8,9) of the first (5) and the second (6) transistor.

## Description

### Field

The present disclosure relates to group III-N devices, such as gallium-nitride devices, formed on a silicon substrate. In particular, the disclosure relates to group III-N High Electron Mobility Transistors (HEMTs).

### State of the art

Group III-N devices, such as gallium-nitride High Electron Mobility Transistors (HEMTs) as discrete component have been widely investigated to be used as power device thanks to their low on-state resistance and high breakdown voltage. Replacing the state-of-the-art Si-based power transistors by Group III-N devices will substantially reduce the energy consumption of power circuits.

These Group III-N devices can be monolithically integrated on a substrate, for example a silicon substrate. For such monolithic integrated devices to be useful in power applications, they must have a sufficient electrical isolation between the individual transistors to avoid failure during operation. Although isolated from each-other, all the monolithic integrated Group III-N transistors still have a common body, i.e. the silicon substrate on which the transistors are formed.

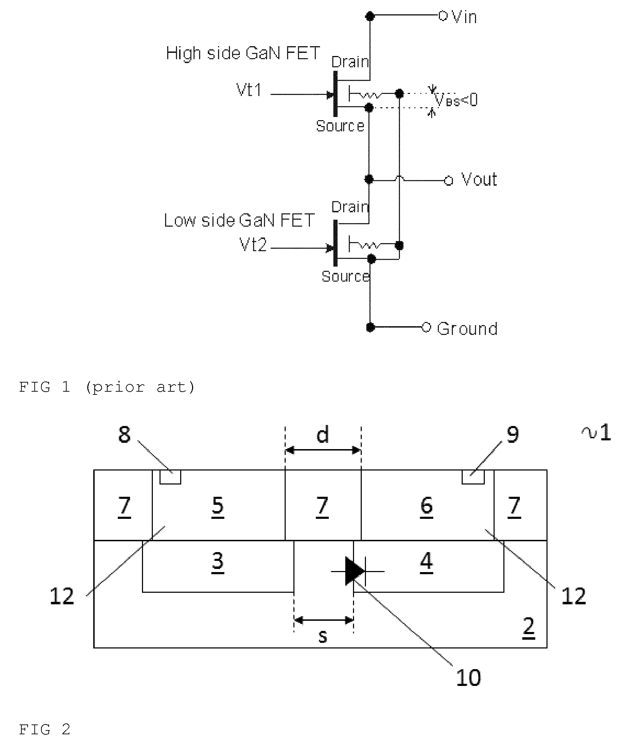

FIG 1 shows a prior art a so-called buck converter. This circuit consists of a high side transistor and a low side transistor which are monolithically integrated on a silicon substrate. The source of the low side transistor is connected to the body, i.e. the Si substrate, and to ground. However, the source of the high side transistor is connected to the drain of the low side transistor instead of to the body, i.e. Si substrate. Due to this connection, a negative bulk-to-source voltage bias is created, V_{BS}<0, causing the threshold voltage Vt1 of the high side transistor to shift to higher positive values compared to the threshold voltage Vt2 of the low side transistor.

Hence, there is a need for an integrated circuit comprising Group III-N transistors, in particular gallium-nitride HEMT devices, monolithically integrated on a silicon substrate, that doesn't suffer from the body effect.

There is a need for an integrated circuit comprising Group III-N transistors, in particular gallium-nitride HEMT devices, monolithically integrated on a silicon substrate, with improved breakdown characteristics.

### Summary

In a first aspect, an integrated circuit (1) is disclosed comprising a first group III-N transistor having a source region and a second group III-N transistor having a source region, both transistors being monolithically integrated on a common silicon substrate of a first doping type and separated from each-other by an isolation region. The substrate comprises underneath the first transistor a well of a first doping type electrically connected to the source region of the first transistor and the substrate comprises underneath the second transistor a well of a second doping type electrically connected to the source region of the second transistor, thereby forming a junction diode in the substrate between the sources of the first and the second transistor.

In such an integrated circuit the wells can be spaced apart or can abut each other.

Optionally a diode is connected between the source regions of the first and the second transistor in parallel with the junction diode.

If the first doping is p-type and the second doping type is n-type, then, when in use, the first well is biased to a voltage lower than of the second well. If the first doping type is n-type and the second doping type is p-type, the, when in use, the first well is biased to a voltage higher than of the second well.

In such integrated circuit each group III-N transistor typically comprises a stack of: a buffer layer formed on the respective well, a group III-N channel stack formed on the buffer layer, a barrier layer formed on the group III-N channel stack, and source and drain regions making ohmic contact with the two-dimensional electron gas formed between the channel stack and the barrier layer, whereby the electrical connection between the respective source regions and wells is through a conductive via extending through the stack of buffer layer, III-N channel stack and barrier layer.

In such integrated circuit more than one group III-N transistor can be present above each well.

In a second aspect a method for manufacturing an integrated circuit according to the first aspect is disclosed, the method comprises providing a silicon substrate of a first doping type, forming in the substrate a first well of a first doping type, and a second well of a second type, thereafter monolithically integrating on the substrate above the first well a first group III-N transistor having a source region and above the second well a second group III-N transistor having a source region, both transistors being separated from each-other by an isolation region, and; forming an electrical contact respectively between the source region of the first transistor and the first well, and between the source region of the second transistor and the second well.

This method for manufacturing an integrated circuit can further comprise monolithically integrating the first group III-N transistor and the second group III-N transistor by forming on the silicon substrate a stack of: a buffer layer, a group III-N channel stack and a barrier layer, forming within the stack electrically isolating regions thereby creating active areas isolated from each-other, forming within each active area a gate region, forming a dielectric passivation layer outside the gate region, forming within each active area a source region and a drain region, thereby removing the dielectric passivation layer at these regions. The electrical contact is formed by forming for each well a conductive via extending through the passivation layer and through the stack of buffer layers, a group III-N channel stack and a barrier layer, to the well thereby electrically connecting the source with the corresponding well, and; forming a metal layer connecting the conductive via with the corresponding source region.

### Brief description of the figures

For the purpose of teaching, drawings are added. These drawings illustrate some aspects and embodiments of the disclosure. They are only schematic and non-limiting. The size of some of the elements may be exaggerated and not drawn on scale for illustrative purposes. The dimensions and the relative dimensions do not correspond to actual reductions to practice of the disclosure. Like features are given the same reference number.
FIG 1 illustrates a prior art so-called buck converter.
FIG 2 illustrates an integrated circuit according to an embodiment.
FIG 3 illustrates an integrated circuit according to another embodiment.
FIG 4 illustrates an embodiment wherein an additional diode is provided.

### Detailed description

The present disclosure will be described with respect to particular embodiments and with reference to certain drawings but the disclosure is not limited thereto. Furthermore, the terms first, second and the like in the description, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein. Moreover, the terms top, under and the like in the description are used for descriptive purposes and not necessarily for describing relative positions. It is to be understood that the terms so used are interchangeable under appropriate circumstances and that the embodiments of the disclosure described herein are capable of operation in other orientations than described or illustrated herein.

As illustrated by FIG 2, an integrated circuit (1) is disclosed comprising a first group III-N transistor (5) having a source region (8) and a second group III-N transistor (6) having a source region (9), both transistors being monolithically integrated on a common silicon substrate (2) of a first doping type and separated (d) from each-other by an isolation region (7), the substrate (2) comprising underneath the first transistor (5) a well (3) of a first doping type electrically connected to the source region (8) of the first transistor (5) and comprising underneath the second transistor (6) a well (4) of a second doping type electrically connected to the source region (9) of the second transistor (6), thereby forming a junction diode (10) in the substrate (2) between the sources (8,9) of the first (5) and the second (6) transistor. Typically the silicon substrate (2) is doped in the range of lel3cm-3 to lel5cm-3, while the wells (3,4) are higher doped, typically in the range of lel6 to lel8cm-3.

An integrated circuit (1) according to this disclosure can be present on bulk silicon wafers, which are less expensive than silicon-on-insulator wafers (SOI), while mitigating the body effect. No additional isolation is needed, thereby reducing the number of costly additional process steps, such as removal of the silicon substrate and transfer to another non-conductive substrate, forming trenches in the substrate around the drain area or forming trenches in the Group III-N stack.

FIG 2 shows the wells (3,4) to be spaced (s) apart. The junction diode (10) is formed between the well (4) and the substrate (2) / the well (3).

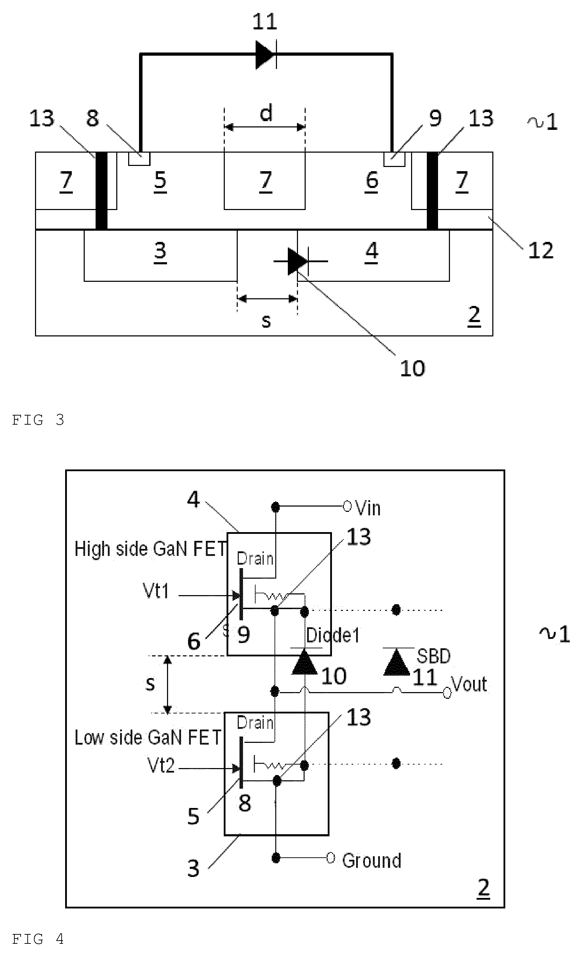

FIG 3 shows an additional diode (11) connected between the source regions (8,9) of the first (5) and the second (6) transistor, i.e. in parallel with the junction diode (10).

FIG 4 shows a schematic of the top view of such an integrated circuit whereby an external diode (11) is placed in parallel with this silicon junction diode (10). This parallel diode can be an external Schottky barrier diode or can be a monolithically integrated gallium-nitride Schottky barrier diode. This additional diode (11) improves the switching characteristics of such integrated circuit (1).

As shown in FIG 2, the substrate (2) and the well (3) underneath the first transistor (5) are p-type doped. Both are at the same potential, preferably grounded. The substrate (2) and the pwell (3) are then connected to a ground pad. This higher doped pwell (3) improves the breakdown voltage of the integrated circuit (1) by suppressing the formation of an inversion layer at the silicon surface adjacent to the stack (12). The well (4) underneath the second transistor (6) is n-type doped. In use, this nwell (4) is biased to a voltage higher than the voltage of the pwell (3). The junction diode (10) between this nwell (4) and the substrate (2)/pwell (3) is thus reverse biased. By selecting the spacing (s) and the doping level of the wells (3,4) and the substrate (2), the breakdown voltage of this diode can be determined to withstand the reverse bias voltage applied during operation of the integrated circuit (1).

Such configuration as shown in FIG 2 is also illustrated by FIG 4 for a so-called buck converter. The high side transistor (6) and the low side transistor (5) are monolithically integrated on a silicon substrate (2). The source (8) of the low side transistor (5) is connected (13) to the body, i.e. the pwell (3) formed in the p-substrate (2), and to ground. The source (9) of the high side transistor (6) is connected (13) to the drain of the low side transistor (5) and to the nwell (4) formed in the p-substrate (2). Due to presence of the wells (3,4) and these connections (13), the bulk-to-source voltage bias of both transistors is zero (V_{BS}=0). Hence the threshold voltage Vt1 of the high side transistor (6) is not shifted compared to the threshold voltage Vt2 of the low side transistor (5). The reverse bias of the silicon junction diode (10) depends on the voltage difference between the output voltage Vout at the output node and the ground.

A skilled person will understand, that the substrate (2) and the well (3) underneath the first transistor (5) can be n-type doped, whereas the well (4) underneath the second transistor (6) is p-type doped. In this configuration, the substrate (2) and the nwell (3) are, in use, biased to a voltage higher than the voltage applied to the pwell (4). The pwell (4) is typically connected to a ground pad (not shown).

As illustrated by FIG 3, each group III-N transistor (5,6) comprises a stack (12) of: a buffer layer formed on the respective well (3,4), a group III-N channel stack formed on the buffer layer and a barrier layer formed on the group III-N channel stack, and source (8,9) and drain regions (not shown) making ohmic contact with the two-dimensional electron gas formed between the channel stack and barrier layer. The layers within the stack (12) further additional layers as known to a person skilled in the art. FIG 3 shows that the electrical connection between the respective source regions (8,9) and wells (3,4) is preferably through a conductive via (13) extending through the stack (12) of buffer layer, III-N channel stack and barrier layer.

A skilled person will understand that an integrated circuit (1) as disclosed can further comprising, above each well (3,4), one or more additional group III-N transistors. If e.g. two or more group III-N transistors (5) are formed above a p-well (3), then the source (8) of the respective transistors (5) are preferably connected with the p-well (3). Instead of having multiple transistors (5) above one well (3) of a particular doping type, multiple wells (3) of that particular doping type can be formed, whereby, above each well (3), only 1 transistor (5) is present.

When an integrated circuit (1) as disclosed is packaged, the p-type substrate (2) can be attached to this package by a heat conducting material, such as a conductive epoxy material, as the high side devices (6) are isolated from the substrate (2) by the diode (10). This connection improves the thermal conductivity of such integrated circuit (1) while grounding the p-type substrate.

An integrated circuit (1) as disclosed in the foregoing paragraphs can be manufactured by a method comprising: providing a silicon substrate (2) of a first doping type, forming in the substrate (2) a first well (3) of a first doping type, and a second well (4) of a second type, monolithically integrating above the first well (3) a first group III-N transistor (5) having a source region (8) and above the second well (4) a second group III-N transistor (6) having a source region (9), both transistors (5,6) being separated from each-other by an isolation region (7), and; forming an electrical contact respectively between the source region (8) of the first transistor (5) and the first well (3), and between the source region (9) of the second transistor (6) and the second well (4).

The first group III-N transistor (5) and the second group III-N transistor (6) can be monolithically integrated by forming on the silicon substrate (2) a stack (12) of a buffer layer, a group III-N channel stack and a barrier layer, forming within the stack electrically isolating regions (7) thereby creating active areas isolated (d) from each-other, forming within each active area a gate region, forming a dielectric passivation layer outside the gate region, forming within each active area a source region (8,9) and a drain region thereby removing the dielectric passivation layer at these regions.

The electrical contact can be formed by, for each well (3,4), forming a conductive via (13) extending through the passivation layer and the stack (12) to the well (3,4) and forming a metal layer connecting the conductive via (13) with the corresponding source region (8,9).

## Claims

1. An integrated circuit (1) comprising:
a first group III-N transistor (5) having a source region (8) and a second group III-N transistor (6) having a source region (9), both transistors being monolithically integrated on a common silicon substrate (2) of a first doping type and separated (d) from each-other by an isolation region (7),
the substrate (2) comprising underneath the first transistor (5) a well (3) of a first doping type electrically connected to the source region (8) of the first transistor (5) and comprising underneath the second transistor (6) a well (4) of a second doping type electrically connected to the source region (9) of the second transistor (6), thereby forming a junction diode (10) in the substrate (2) between the sources (8,9) of the first (5) and the second (6) transistor.

2. A circuit according to claim 1, wherein:
both wells (3,4) are spaced (s) apart.

3. A circuit according to any of the foregoing claims, further comprising:
a diode (11) connected between the source regions (8,9) of the first (5) and the second (6) transistor in parallel with the junction diode (10).

4. A circuit according to any of the foregoing claims, wherein:
the first doping is p-type and the second doping type is n-type, and, when in use, the first well (3) is biased to a voltage lower than of the second well (4).

5. A circuit according to any of foregoing claims, wherein:
the first doping type is n-type and the second doping type is p-type, and, when in use, the first well (3) is biased to a voltage higher than of the second well (4).

6. A circuit according to any of the foregoing claims, wherein:
each group III-N transistor (5,6) comprises a stack (12) of: a buffer layer formed on the respective well (3,4), a group III-N channel stack formed on the buffer layer, a barrier layer formed on the group III-N channel stack and source and drain regions making ohmic contact with the two-dimensional electron gas formed between the channel stack and the barrier layer.
whereby the electrical connection between the respective source regions and wells is through a conductive via extending through the stack (12) of buffer layer, III-N channel stack and barrier layer.

7. A circuit according to any of the foregoing claims, further comprising, above each well (3,4), at least one additional group III-N transistor.

8. A method for manufacturing an integrated circuit according to any of the claims 1 to 7, the method comprising:
- providing a silicon substrate (2) of a first doping type,
- forming in the substrate (2) a first well (3) of a first doping type, and a second well (4) of a second type,
- thereafter monolithically integrating on the substrate (2) above the first well (3) a first group III-N transistor (5) having a source region (8) and above the second well (4) a second group III-N transistor (6) having a source region (9), both transistors (5,6) being separated from each-other by an isolation region (7), and;
- forming an electrical contact respectively between the source region (8) of the first transistor (5) and the first well (3), and between the source region (9) of the second transistor (6) and the second well (4).

9. A method for manufacturing an integrated circuit according to claim 8, wherein:
monolithically integrating the first group III-N transistor (5) and the second group III-N transistor (6) comprises:
- forming on the silicon substrate (2) a stack (12) of: a buffer layer, a group III-N channel stack and a barrier layer,
- forming within the stack (12) electrically isolating regions (7) thereby creating active areas isolated from each-other,
- forming within each active area a gate region,
- forming a dielectric passivation layer outside the gate region,
- forming within each active area a source region (8,9) and a drain region thereby removing the dielectric passivation layer at these regions, and;
wherein forming the electrical contact comprises:
- forming for each well (3,4) a conductive via extending through the passivation layer and through the stack of buffer layer, a group III-N channel stack and a barrier layer, to the well (3,4) thereby electrically connecting the source (8,9) with the corresponding well (3,4), and;
- forming a metal layer connecting the conductive via with the corresponding source region (8,9).
